# FASCICULE DE BREVET EUROPEEN

(11) **EP 3 820 657 B1**
(45) Date de publication et mention de la délivrance du brevet: **31.08.2022**
(21) Numéro de dépôt: 19735567.0
(22) Date de dépôt: 04.07.2019
(51) Int. Cl.: B25J 13/08, B25J 19/00, B25J 19/06, G01D 15/00, H03K 17/955

(54) **APPAREIL MUNI D'UNE DETECTION CAPACITIVE ET DE LIGNE(S) ELECTRIQUE(S) DANS LA ZONE DE DETECTION CAPACITIVE**
VORRICHTUNG MIT KAPAZITIVER ERFASSUNG UND ELEKTROLEITUNG(EN) IN DER KAPAZITIVEN ERFASSUNGSZONE
APPARATUS PROVIDED WITH A CAPACITIVE DETECTION AND ELECTRICAL LINE(S) IN THE CAPACITIVE DETECTION ZONE

(30) Priorité: 13.07.2018 FR 1856484
(43) Date de publication de la demande: 19.05.2021
(73) Titulaire: Fogale Nanotech, 30900 Nimes (FR)
(72) Inventeur: CHAKOUR, Yacine, 30210 Sernhac (FR); ROZIERE, Didier, 30900 Nîmes (FR); COURTEVILLE, Alain, 30111 Congenies (FR)
(74) Mandataire: IPAZ
(86) Numéro de dépôt international: PCT/EP2019/067949
(87) Numéro de publication internationale: WO 2020/011633

(56) Documents cités:
- FR-A1- 3 051 896
- JP-U- H 042 420
- US-A- 5 166 679

## Description

### Domaine technique

La présente invention concerne un appareil, tel qu'un robot, muni d'une détection capacitive d'objet(s) et d'au moins une ligne électrique dans la zone de détection capacitive.

Le domaine de l'invention est, de manière non limitative, celui du domaine de la robotique, en particulier le domaine de la robotique industrielle ou des robots de service, par exemple médical ou domestique, ou encore des robots collaboratifs, également appelés « cobots ».

### Etat de la technique

Dans le domaine de la robotique collaborative, les robots peuvent être équipés de capteurs capacitifs pour détecter l'approche d'objets ou d'opérateurs humains dans le voisinage dudit robot. Ces capteurs peuvent par exemple comprendre des électrodes capacitives agencées sous la forme de surfaces sensibles qui recouvrent au moins partiellement la surface du robot. Ces électrodes capacitives sont polarisées à un potentiel d'excitation alternatif, et reliées à une électronique de détection qui mesure le couplage capacitif entre ces électrodes et des objets polarisés à un potentiel différent des électrodes, le plus souvent la masse.

Ces robots sont en général équipés d'outils ou d'accessoires, référencés à la masse, et reliés à des électroniques de commande ou des alimentations par des câbles électriques qui passent dans des chemins de câble le long du robot.

On connaît des documents FR3051896A1, JP H042420 U et US 5 166 679 A l'utilisation d'électrodes capacitives comme capteur de proximité sur la surface externe d'un bras robotisé, ou l'utilisation de lignes électriques équipés de capteurs de contact le long d'un bras robotisé.

Lorsque ces câbles sont à proximité d'une surface de capteurs capacitifs, ils peuvent être détectés comme des obstacles et déclencher des procédures de sécurité de manière erronée. Ces câbles peuvent aussi perturber le fonctionnement des capteurs capacitifs en termes de précision et de portée de détection.

Un but de la présente invention est de pallier ces inconvénients.

Un autre but de l'invention est de proposer une solution permettant le passage d'un câble polarisé à un potentiel différent du potentiel d'un capteur capacitif, à proximité dudit capteur capacitif, sans perturber le fonctionnement dudit capteur capacitif.

Il est aussi un but de la présente invention de proposer une solution permettant le passage d'un câble polarisé à un potentiel différent du potentiel d'un capteur capacitif, à proximité dudit capteur capacitif, sans être détecté par ce capteur.

### Exposé de l'invention

Au moins un de ces buts est atteint avec un appareil comprenant :
- au moins une électrode, dite de mesure, polarisée à un potentiel électrique alternatif, dit de détection, différent d'un potentiel de masse, à une fréquence, dite de détection, pour détecter au moins un objet dans une zone de détection,
- au moins une électronique de détection capacitive, reliée auxdites électrodes de mesure, pour détecter un signal relatif à une capacité de couplage entre ledit objet et ladite électrode de mesure, et
- une ligne électrique comprenant au moins un fil électrique, dans ladite zone de détection ;
ledit appareil comprenant en outre un conditionneur, appliquant, à au moins une partie de ladite ligne électrique, un potentiel électrique alternatif, dit de garde, identique audit potentiel de détection à ladite fréquence de détection.

Ainsi, l'appareil selon l'invention propose de porter au moins une partie de la ligne électrique à un potentiel de garde, identique au potentiel de détection polarisant les électrodes de mesure à la fréquence de détection. Ce faisant, toute la partie de la ligne électrique polarisée au potentiel de garde devient électriquement invisible pour les électrodes de mesure. Ainsi, la ligne électrique ne vient pas perturber la détection capacitive équipant l'appareil, et ne provoque pas de détections erronées ou abusives, pouvant déclencher des procédures de sécurité de manière erronée.

Par conséquent, grâce à la présente invention, il devient possible d'utiliser, dans un appareil, une détection capacitive efficace, tout en positionnant une ligne électrique dans la zone de détection capacitive pour transporter un signal d'alimentation, de commande, de contrôle et/ou de communication, vers/depuis un organe dudit appareil, ou un autre appareil.

Dans la présente demande, deux potentiels alternatifs sont identiques à une fréquence donnée lorsqu'ils comportent chacun une composante alternative identique ou similaire à cette fréquence, c'est-à-dire de même amplitude (par exemple à quelques pourcents près) et de même phase (par exemple à quelques degrés près). Ainsi, l'un au moins des deux potentiels identiques à ladite fréquence peut comporter en outre une composante continue, et/ou une composante alternative de fréquence différente de ladite fréquence donnée.

De manière similaire, deux potentiels alternatifs sont différents à la fréquence donnée lorsqu'ils ne comportent pas de composante alternative identique ou similaire à cette fréquence donnée.

Dans la présente demande, le terme « potentiel de masse » ou « potentiel de masse générale » désigne un potentiel de référence de l'électronique, du robot ou de son environnement, qui peut être par exemple une masse électrique ou un potentiel de masse. Ce potentiel de masse peut correspondre à un potentiel de terre, ou à un autre potentiel relié ou non au potentiel de terre.

On rappelle par ailleurs que de manière générale, les objets qui ne sont pas en contact électrique direct avec un potentiel électrique particulier (objets électriquement flottants) tendent à se polariser par couplage capacitif au potentiel électrique d'autres objets présents dans leur environnement, tel que par exemple la terre ou des électrodes, si les surfaces de recouvrement entre ces objets et ceux de l'environnement (ou les électrodes) sont suffisamment importantes.

Dans la présente demande, « objet » désigne tout objet, ou toute personne, pouvant se trouver dans l'environnement du robot.

La ligne électrique peut comprendre au moins une couche de blindage autour d'au moins un fil électrique sur au moins une partie de ladite ligne électrique.

Dans ce cas, le conditionneur peut appliquer le potentiel de garde à ladite couche de blindage.

Ainsi, chaque fil électrique se trouvant entouré par la couche de blindage est électriquement gardé par la couche de garde et ne vient pas perturber la détection capacitive, tout en véhiculant n'importe quel potentiel électrique.

Suivant un premier mode de réalisation non limitatif, la couche de blindage peut être prévue dans un câble comprenant l'au moins un fil électrique.

Dans ce cas, la couche de blindage est solidaire du câble et fait partie du câble. Elle ne peut donc pas être dissociée du câble sans détériorer le câble.

Il existe actuellement des câbles avec une couche de blindage, par exemple utilisée comme écran de blindage électromagnétique. L'invention propose d'utiliser cette couche de blindage existante comme couche de garde, en polarisant cette couche de blindage au potentiel de garde : ce qui est simple, rapide et ne nécessite pas de modification des câbles existants.

Suivant une configuration habituelle des câbles, la couche de blindage peut être en outre protégée à l'extérieur par une couche électriquement isolante pour éviter les courts-circuits notamment vers la masse.

Suivant un autre mode de réalisation non limitatif, la couche de blindage peut être prévue dans, ou peut être formée par, un passe câble, indépendant de l'au moins un fil électrique, et dans lequel est passé l'au moins un fil électrique.

Dans ce cas, la couche de blindage est indépendante des fils électriques, ou du câble, formant la ligne électrique. Autrement dit, la couche de blindage peut être dissociée des fils électrique, ou du câble électrique, sans le(s) détériorer.

Il existe actuellement des passes-câbles ou des gaines de câbles munis, ou formant, une couche de blindage utilisée comme écran de blindage électromagnétique. Il existe également des passes-câbles ou des gaines de câbles avec une enveloppe métallique annelée réalisant un blindage mécanique pour protéger les fils électriques ou les câbles des écrasements et des arrachements. L'invention propose d'utiliser un tel passe-câble comme couche de garde, en polarisant la couche de blindage dudit passe-câble au potentiel de garde : ce qui est simple, rapide et ne nécessite pas de modification des câbles ou fils électriques utilisés, ou des passe-câbles, existants.

En outre, le passe-câble ou la gaine peut avantageusement comprendre une couche électriquement isolante sur la couche de blindage, pour éviter les courts-circuits notamment vers la masse.

La couche de blindage peut par exemple se présenter sous la forme de fils tressés formant une tresse de blindage.

La tresse peut être réalisée par un fil, ou par plusieurs fils, conducteur d'électricité.

La couche de blindage peut se présenter sous la forme d'une couche conductrice continue, telle qu'une couche de cuivre ou d'aluminium par exemple, ou une paroi en inox annelée.

Suivant un mode de réalisation non limitatif, le conditionneur peut comprendre un transformateur induisant le potentiel de garde sur la couche de blindage, par mutuelle inductance.

Dans ce cas, le transformateur peut comprendre une bobine primaire d'induction qui est couplée électromagnétiquement avec au moins une bobine secondaire en série avec la couche de blindage.

Les bobines primaire et secondaire peuvent par exemple être bobinées sur un noyau ferromagnétique commun augmentant le couplage entre lesdites bobines. Ainsi, en portant la bobine primaire au potentiel de garde ou à un potentiel proportionnel au potentiel de garde pour tenir compte du couplage entre les bobines, on obtient par mutuelle inductance le potentiel de garde aux bornes de la bobine secondaire reliée à la couche de blindage : la couche de blindage est alors portée au potentiel de garde.

Suivant un autre mode de réalisation, le conditionneur peut comprendre au moins un contact électrique avec la couche de blindage pour polariser ladite couche de blindage au potentiel de garde.

Cet au moins un contact électrique peut relier la couche de garde à une source délivrant le potentiel de garde.

Alternativement, ou en plus, le conditionneur peut appliquer le potentiel de garde à au moins un, en particulier chaque, fil électrique de la ligne électrique.

Dans ce cas, le ou chaque fil électrique se trouve au potentiel de garde. Autrement dit, le ou chaque fil électrique peut véhiculer un ou plusieurs potentiels dont l'un correspond au potentiel de garde.

Ainsi, à la fréquence de détection de l'électronique capacitive, chaque fil électrique devient électriquement « invisible » pour les électrodes de mesure réalisant la détection capacitive.

La ligne électrique peut comprendre des fils électriques concentriques, de sorte qu'un ou plusieurs fils électriques sont disposés dans un autre fil, dit fil externe, qui les entoure.

Dans ce cas, le conditionneur peut appliquer le potentiel de garde uniquement au fil externe.

Dans ce cas, ledit fil externe garde électriquement le ou les autres fils électriques qui sont disposés dans ledit fil externe de manière concentrique. Il n'est donc pas nécessaire de porter au potentiel de garde les fils se trouvant dans le fil externe.

Suivant un mode de réalisation, le conditionneur peut comprendre, pour au moins un, en particulier chaque, fil électrique, un transformateur induisant le potentiel de garde sur ledit fil électrique, par mutuelle inductance.

Dans ce cas, le transformateur peut comprendre une bobine primaire d'induction qui est couplée électromagnétiquement avec au moins une bobine secondaire en série avec le fil électrique.

Les bobines primaire et secondaire peuvent par exemple être bobinées sur un noyau ferromagnétique commun augmentant le couplage entre lesdites bobines.

Ainsi, en portant la bobine primaire au potentiel de garde ou à un potentiel proportionnel au potentiel de garde pour tenir compte du couplage entre les bobines, on obtient par mutuelle inductance le potentiel de garde aux bornes de la bobine secondaire reliée au fil électrique : le fil électrique est alors porté au potentiel de garde à la fréquence de détection.

L'appareil selon l'invention peut en outre comprendre au moins une électrode, dite de garde, polarisée au potentiel de garde, et agencée du côté opposée à la zone de détection par rapport à l'au moins une électrode de mesure.

Un telle au moins une électrode de garde permet de garder électriquement l'au moins une électrode de mesure, et éviter qu'elle soit perturbée par d'autres surfaces/organes de l'appareil, et se trouvant à un potentiel différent du potentiel de détection.

Suivant une caractéristique avantageuse, la ligne électrique peut comporter au moins une électrode de mesure capacitive polarisée au potentiel de détection, disposée à l'extérieure par rapport à la partie de ladite ligne électrique polarisée au potentiel de garde, et isolée de ladite partie polarisée au potentiel de garde.

Ainsi, la ligne électrique participe à la détection capacitive.

L'appareil selon l'invention permet ainsi d'éviter des collisions entre ladite ligne électrique et des objets environnants.

L'au moins une électrode de mesure peut être disposée sur une surface externe de la ligne électrique, isolée du reste de la ligne électrique. Cette surface externe peut être une surface externe d'un passe-câble lorsque la ligne électrique en comporte un. La surface externe peut être une surface externe d'un câble formant la ligne électrique.

La ligne électrique peut être une ligne d'alimentation de, et/ou de communication avec, un organe électrique dudit appareil.

La détection capacitive mise en œuvre dans l'appareil selon l'invention est basée sur la mesure/détection d'un signal de couplage capacitif entre au moins une électrode de mesure et l'objet à détecter.

Pour ce faire, l'électronique de détection capacitive peut comprendre une électronique, numérique et/ou analogique, pour d'une part :
- fournir le potentiel de détection et le potentiel de garde, à la fréquence de détection ;
- mesurer/détecter un signal relatif au couplage électrode-objet. Suivant un exemple de réalisation, l'électronique de détection peut comprendre un amplificateur opérationnel (AO), ou un circuit réalisant un amplificateur opérationnel, fonctionnant en amplificateur de transimpédance ou de charge, dont :
   - une première entrée, par exemple inverseuse, est reliée à une ou des électrodes de mesure, directement ou par l'intermédiaire d'un moyen de scrutation par exemple ;
   - une deuxième entrée, par exemple non inverseuse, est reliée à un oscillateur fournissant le potentiel de détection et le potentiel de garde ; et
   - la sortie est rebouclée sur ladite première entrée par l'intermédiaire d'une impédance, et en particulier d'une capacité.

Dans cette configuration, la sortie de l'AO fournit une tension Vₛ dont l'amplitude est proportionnelle à la capacité électrode-objet entre au moins une électrode de mesure et l'objet.

La sortie de l'amplificateur opérationnel peut être reliée, directement ou indirectement, à un module de mesure de la tension V_{S}. Ce module de mesure de la tension V_{S} peut comprendre un conditionneur, une démodulation telle qu'une démodulation synchrone à la fréquence de détection, ou une détection d'amplitude.

L'électronique de détection peut en outre comprendre un oscillateur fournissant le potentiel alternatif de détection à la fréquence de détection et le potentiel de garde.

Ce potentiel de détection peut comprendre un signal sinusoïdal, ou carré, ou de toute autre forme d'onde. La fréquence de détection peut correspondre à la fréquence fondamentale de cette forme d'onde.

Avantageusement, l'électronique de détection peut être, au moins en partie, référencée électriquement au potentiel de détection.

L'appareil selon l'invention peut se présenter sous la forme d'un robot.

Suivant des exemples de réalisation nullement limitatifs, le robot peut être ou comprendre tout système robotisé. Il peut en particulier se présenter sous la forme de, ou comprendre, un bras robotisé.

Le robot peut également être, ou comprendre, par exemple un robot mobile, un véhicule sur roues ou chenilles tel qu'un chariot muni d'un bras ou d'un système manipulateur, ou un robot de type humanoïde, gynoïde ou androïde, éventuellement pourvu d'organes de déplacement tels que des membres.

### Description des figures et modes de réalisation

D'autres avantages et caractéristiques apparaîtront à l'examen de la description détaillée d'exemples nullement limitatifs, et des dessins annexés sur lesquels :
- la FIGURE 1 est une représentation schématique d'un exemple de réalisation non limitatif d'une électronique de détection capacitive pouvant être mise en œuvre dans le dispositif selon l'invention ;
- la FIGURE 2 est une représentation schématique partielle d'un exemple de réalisation non limitatif d'un appareil selon l'invention ;
- les FIGURES 3-5 sont des représentations schématiques d'exemples de réalisation d'une mise au potentiel de garde d'une ligne électrique dans un appareil selon l'invention ; et
- la FIGURE 6 est une représentation schématique d'un exemple de réalisation non limitatif d'un robot selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

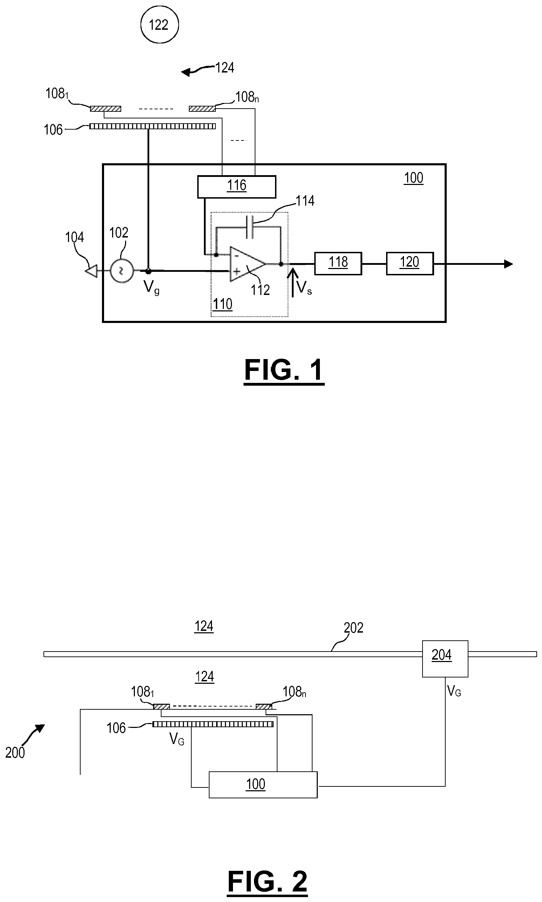

La FIGURE 1 est une représentation schématique d'un exemple de réalisation non limitatif d'une électronique de détection capacitive pouvant être mise en œuvre dans le dispositif selon l'invention.

L'électronique de détection 100, représentée sur la FIGURE 1, peut être réalisée sous une forme analogique ou numérique, ou une combinaison analogique/numérique.

L'électronique de détection 100 comprend un oscillateur 102 délivrant une tension alternative, notée V_{G}, et référencé à un potentiel de masse 104.

La tension V_{G} est utilisée comme potentiel de garde pour polariser une ou des électrodes de garde 106 par l'intermédiaire d'une ligne ou plusieurs lignes, et comme potentiel d'excitation ou de détection pour polariser des électrodes de mesure 108₁-108ₙ, pouvant être également désignée par la référence 108, ou la référence 108ᵢ, dans la suite. Elle comprend donc au moins une composante spectrale à la fréquence de détection utilisée par l'électronique de détection capacitive.

L'électronique de détection 100 comprend un amplificateur de courant, ou de charge, 110 représenté par un amplificateur opérationnel (AO) 112 et une capacité de contre-réaction 114 rebouclant la sortie de l'AO 112 à l'entrée inverseuse « - » de l'AO 112.

De plus, dans l'exemple représenté, l'entrée non-inverseuse « + » de l'AO 112 reçoit la tension V_{G} et l'entrée inverseuse « - » de l'AO 112 est prévue pour être reliée à chaque électrode de mesure 108ᵢ par l'intermédiaire d'un moyen de scrutation 116, qui peut être par exemple un switch, de sorte à interroger individuellement à tour de rôle les électrodes de mesure 108.

L'utilisation du moyen de scrutation 116 est, bien entendu, optionnelle.

Dans ces conditions, l'amplificateur de charge 110, et en particulier l'AO 112, fournit en sortie une tension Vs à la fréquence de détection et d'amplitude proportionnelle à la capacité de couplage Cₑₒ, dite capacité électrode-objet, entre une ou plusieurs électrodes de mesure 108 reliée à son entrée « - » et un objet à proximité, ou en contact, de ladite électrode de mesure 108.

L'électronique de détection 100 peut en outre comprendre un conditionneur 118 permettant d'obtenir un signal représentatif de la capacité de couplage Cₑₒ recherchée. Ce conditionneur 118 peut comprendre, par exemple, un démodulateur synchrone pour démoduler le signal par rapport à une porteuse, à la fréquence de détection. Le conditionneur 118 peut également comprendre un démodulateur asynchrone ou un détecteur d'amplitude. Ce conditionneur 118 peut, bien entendu, être réalisé sous une forme analogique et/ou numérique (microprocesseur) et comprendre tous moyens nécessaires de filtrage, de conversion, de traitement, etc.

Le conditionneur 118 mesure et fournit la valeur de la tension Vs.

L'électronique de détection 100 peut en outre comprendre un module de calcul 120 agencé pour déterminer une distance ou une information de distance, et/ou un contact ou une information de contact, entre au moins une électrode de mesure 108 et l'objet, en fonction du signal relatif à la capacité de couplage Ceo issu du conditionneur 118.

Ce module de calcul 120 peut par exemple comprendre ou être réalisé sous la forme d'un microcontrôleur, ou d'un FPGA.

Le module de calcul 120 peut également fournir d'autres informations, telles que des déclenchements d'alarmes ou de procédures de sécurité, lorsque par exemple les distances mesurées sont inférieures à des seuils de distance prédéterminés.

Bien entendu, l'électronique de détection 100 peut comprendre d'autres composants que ceux décrits.

L'électronique de détection 100, ou au moins sa partie sensible avec l'amplificateur de charge 110 peut être référencée (ou alimentée par des alimentations électriques référencées) au potentiel de garde V_{G}, pour minimiser les capacités parasites.

L'électronique de détection 100 peut également être référencée, de manière plus classique, au potentiel de masse 104.

Ainsi, lorsqu'un objet 122 entre dans la zone de détection 124 de la ou des électrodes de mesure 108₁-108ₙ, cet objet 122 vient en couplage capacitif avec au moins une électrode de mesure 108, ce qui modifie la capacité vue par cette électrode de mesure 108, et donc l'amplitude de la tension V_{S} mesurée par l'électronique de mesure 100 reliée à cette électrode de mesure 108.

La FIGURE 2 est une représentation schématique partielle d'un exemple de réalisation non limitatif d'un appareil selon l'invention.

L'appareil 200, représenté sur la FIGURE 2, comprend les électrodes de mesure 108₁-108ₙ, la ou les électrodes de garde 106, ainsi que l'électronique de détection 100.

Les électrodes de mesure 108₁-108ₙ, respectivement la ou les électrodes de garde 106, peuvent être disposées, par exemple, sur/dans une paroi externe de l'appareil 200. En particulier, les électrodes 106-108 peuvent être disposées, par exemple, sur/dans une coque rigide, ou souple, de l'appareil 200, ou dans une couche, ou une peau, rapportée sur une partie de l'appareil 200.

L'appareil 200 peut en outre comprendre une ligne électrique 202 se trouvant dans la zone de détection 124 des électrodes de mesure 108₁-108ₙ, du côté opposée à l'au moins une électrode de garde 106. Cette ligne électrique 202 peut comprendre un ou plusieurs fils électriques, ou câbles électriques, utilisés pour transporter un signal électrique d'alimentation d'un, ou de communication avec un, organe de l'appareil 200.

L'appareil 200 comprend en outre un conditionneur 204, appliquant, à au moins une partie de ladite ligne électrique 202, le potentiel de garde V_{G}. Ainsi, la ligne électrique 202 n'est pas visible par les électrodes de mesure 108₁-108ₙ et ne vient pas perturber la détection capacitive réalisée par ces électrodes de mesure 108₁-108ₙ.

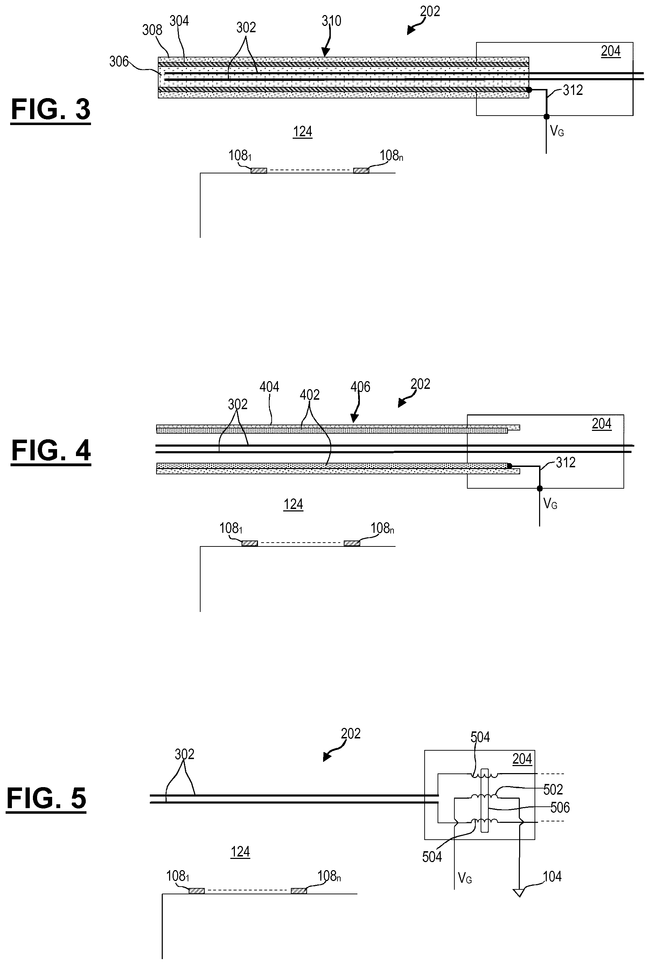

La FIGURE 3 est une représentation schématique d'un premier exemple de réalisation d'une mise au potentiel de garde d'une ligne électrique dans un appareil selon l'invention.

Dans l'exemple représenté sur la FIGURE 3, la ligne 202 comprend un ou plusieurs fils électriques 302 utilisés pour transporter des signaux électriques, par exemple pour alimenter un organe électrique ou pour communiquer avec un organe électrique ou électronique.

La ligne électrique 202 comprend une couche de blindage 304, disposée autour des fils électriques 302. La couche de blindage 304 peut être réalisée par des fils électriques tressés, ou par une fine couche d'un matériau conducteur d'électricité tel que du cuivre ou de l'aluminium par exemple.

La couche de blindage conductrice 304 est séparée de chacun des fils électriques par un isolant 306. Elle est elle-même recouverte d'une couche isolante 308 pour éviter tout contact électrique avec l'environnement, hormis dans le conditionneur.

Dans l'exemple représenté sur la FIGURE 3, les fils électriques 302 et la couche de blindage 304, les isolants 306-308 font partie d'un même câble 310 se présentant sous la forme d'un ensemble monobloc. Autrement dit, la couche de blindage 304 est un des constituants du câble 310 et ne peut pas être séparée des fils 302 sans dégrader le câble 310.

Le conditionneur 204 comprend une ligne, ou une interface, 312 reliée par une liaison électrique à la couche de blindage 304. Cette ligne 312 amène le potentiel V_{G}, reçu par le conditionneur 204, à la couche de blindage 304 de sorte que ladite couche de blindage 304 est polarisée audit potentiel de garde VG.

Ainsi, les fils électriques 302, entourés par la couche de blindage 304, sont gardés au potentiel de garde V_{G} et ne sont pas visibles par les électrodes de mesure 108₁-108ₙ.

Dans l'exemple illustré, la couche de blindage 304 n'est présente sur la ligne électrique 202 que d'un côté du conditionneur 204, en sortie de ce conditionneur. Elle peut bien entendu être également présente sur la ligne électrique 202 de l'autre côté du conditionneur, en entrée. Dans ce cas, elle peut être :
- soit également reliée au potentiel de garde V_{G} ;
- soit reliée à un autre potentiel tel que la masse, ou électriquement flottante, auquel cas elle est électriquement interrompue au niveau du conditionneur 204 entre l'entrée et la sortie.

De manière optionnelle, la ligne électrique 202 peut comporter une ou plusieurs électrodes de mesures disposées sur la surface extérieure du câble 310 et reliées à une électronique de détection capacitive.

La FIGURE 4 est une représentation schématique d'un deuxième exemple de réalisation d'une mise au potentiel de garde d'une ligne électrique dans un appareil selon l'invention.

Dans l'exemple représenté sur la FIGURE 4, la ligne 202 comprend les fils électriques 302 utilisés pour transporter des signaux électriques, par exemple pour alimenter un organe électrique ou pour communiquer avec un organe électrique ou électronique.

La ligne électrique 202 comprend une couche de blindage 402, électriquement conductrice, incluse dans une gaine passe-câbles disposée autour des fils électriques 302. La couche de blindage 402 peut être réalisée notamment par la paroi métallique d'une gaine passe câble métallique annelée, réalisée avec une bande métallique hélicoïdale, ou par une couche de blindage de la gaine passe-câble, avec des fils électriques tressés, ou une fine couche d'un matériau conducteur d'électricité, tel que du cuivre ou de l'aluminium par exemple.

La couche de blindage conductrice 402 peut être recouverte d'une couche électriquement isolante 404, pour éviter tout contact électrique avec l'environnement, hormis dans le conditionneur.

Dans l'exemple représenté sur la FIGURE 4, la couche de blindage 402 fait partie de, ou forme, un passe-câble 406. Autrement dit, la couche de blindage 402 est indépendante des fils 302, et peut être produite et installée de manière indépendante des fils 302. De plus, au moins un fil 302 peut être enlevé, respectivement ajouté, sans avoir à modifier la ligne électrique 202, ni le passe-câble 406.

Le conditionneur 204 comprend la ligne, ou l'interface, 312 amenant le potentiel V_{G}, reçu par le conditionneur 204, à la couche de blindage 402 de sorte que ladite couche de blindage 402 est polarisée audit potentiel de garde V_{G}.

Ainsi, les fils électriques 302, entourés par la couche de blindage 402, sont gardés au potentiel de garde V_{G} et ne sont pas visibles par les électrodes de mesure 108₁-108ₙ.

Dans l'exemple illustré, la couche de blindage 402 n'est présente sur la ligne électrique 202 que d'un côté du conditionneur 204, en sortie de ce conditionneur. Elle peut bien entendu être également présente sur la ligne électrique 202 de l'autre côté du conditionneur, en entrée. Dans ce cas, elle peut être :
- soit également reliée au potentiel de garde V_{G} ;
- soit reliée à un autre potentiel tel que la masse, ou électriquement flottante, auquel cas elle est électriquement interrompue au niveau du conditionneur 204 entre l'entrée et la sortie.

De manière optionnelle, la ligne électrique 202 peut comporter une ou plusieurs électrodes de mesures disposées sur une surface extérieure du passe-câble 406, et reliées à une électronique de détection capacitive.

La FIGURE 5 est une représentation schématique d'un troisième exemple de réalisation d'une mise au potentiel de garde d'une ligne électrique dans un appareil selon l'invention.

Dans l'exemple représenté sur la FIGURE 5, la ligne 202 comprend les fils électriques 302 utilisés pour transporter des signaux électriques, par exemple pour alimenter un organe électrique ou pour communiquer avec un organe électrique ou électronique.

Dans l'exemple représenté sur la FIGURE 5, le conditionneur 204 comprend :
- une inductance primaire 502 alimentée par le potentiel V_{G} ou par un potentiel proportionnel à V_{G}; et
- pour chaque fil électrique 302, une inductance secondaire 504 en série avec ladite ligne électrique 302.

Chacune des inductances 502-504 peut être formée par une bobine par exemple.

L'inductance primaire 502 est en couplage inductif avec chacune des inductances secondaires 504, de sorte à générer par couplage inductif au niveau de chacune des inductances secondaires 504 le potentiel V_{G}. Le potentiel V_{G} généré au niveau de chaque inductance secondaire 504 vient ainsi s'ajouter, ou se superposer, au signal électrique transporté par la ligne électrique 302 à laquelle est reliée ladite inductance secondaire 504. Plus précisément, on insère ainsi une source de tension V_{G}, ou un générateur de Thévenin, en série sur toutes les lignes électriques 302.

Ainsi, chaque ligne électrique 302 en sortie du conditionneur 204 est polarisée (par rapport à la masse) au potentiel de garde V_{G} et n'est donc pas visible par les électrodes de mesure 108₁-108ₙ.

Il est à noter que les signaux transportés par les lignes électriques 302 en plus du potentiel de garde V_{G} ne perturbent pas la mesure capacitive tant qu'ils n'ont pas de composante (ou au moins pas de composante détectable) à la fréquence de mesure.

Par ailleurs, le potentiel des lignes électriques 302 n'est pas affecté en entrée du conditionneur, donc le conditionneur 204 n'a pas d'influence sur l'électronique qui se trouve en amont de ce conditionneur.

Ce mode de réalisation nécessite que la somme des courants dans les lignes électriques 302 soit nul. Cette condition est réalisée dès lors que la masse ou le potentiel de référence de l'électronique en aval du conditionneur est également transmise par une ligne électrique 302, ce qui est en général le cas en pratique pour des raisons de protection électrique des outils.

En outre, dans ce cas, le conditionneur 204 n'a pas d'influence sur l'électronique qui se trouve en aval de ce conditionneur, puisque les différences de potentiel entre les lignes électriques 302 sont toutes conservées.

De préférence, l'inductance primaire 502 et les inductances secondaires 504 sont bobinées sur un noyau ferromagnétique 506 commun, de sorte à optimiser les couplages par mutuelle inductance. L'ensemble forme ainsi un transformateur. Le potentiel appliqué à l'inductance primaire 502 est choisi de sorte à générer des potentiels V_{G} dans les inductance secondaire 504, en tenant compte des couplage inductifs réels.

La ligne électrique 202 de la FIGURE 5 ne comprend rien d'autre que les fils électriques 302. De manière optionnelle, suivant des alternatives non représentées, la ligne électrique 202 peut comprendre :
- la couche d'isolation 404, par exemple dans le cas où la ligne électrique 202 comprend, ou est formée par, un passe câble dans lequel sont passés les fils électriques 302 ;
- la couche d'isolation 306 et/ou la couche d'isolation 308, par exemple dans le cas où la ligne électrique 202 comprend, ou est formée par, un câble électrique comprenant les fils électriques 302.

Par ailleurs, le conditionneur 204 de la FIGURE 5 peut être utilisé dans chacun des exemples décrits en référence aux FIGURES 3 et 4.

Suivant encore une autre alternative, lorsque la ligne électrique comprend des conducteurs/fils électriques concentriques, il est suffisant de polariser au potentiel de garde seulement le fil électrique externe. Dans ce cas, le conditionneur peut comprendre une inductance secondaire uniquement pour le fil externe.

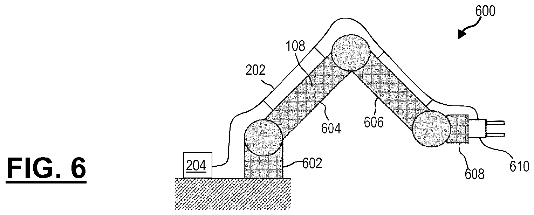

La FIGURE 6 est une représentation schématique d'un exemple de réalisation non limitatif d'un robot selon l'invention.

Le robot 600, représenté sur la FIGURE 6, est un bras robotisé tel qu'un robot collaboratif industriel travaillant sous la surveillance, ou en collaboration avec, un opérateur, ou encore un robot médical en vue d'une intervention sur le corps d'une personne, ou encore un robot d'assistance à la personne.

Le bras robotisé 600 comprend un segment fixe 602, trois segments articulées 604-608 et une tête fonctionnelle 610 fixé au segment 608. La tête fonctionnelle 610 est une pince munie d'un moteur électrique (non représenté).

Chaque segment 602-608 est doté d'électrodes de mesures 108 pour réaliser une détection capacitive d'objets se trouvant dans l'environnement du bras robotisé 600, en particulier déposées dans/sur la coque extérieure dudit segment.

Le bras robotisé 600 comprend une ligne 202 pour alimenter la tête fonctionnelle et/ou pour communiquer avec la tête fonctionnelle et d'un conditionneur 204 pour appliquer un potentiel de garde à la ligne 202 selon l'un quelconque des exemples décrits en référence aux FIGURES 3-5.

Le conditionneur 204 peut être indépendant du bras robotisé 600.

Alternativement, le conditionneur 204 peut être intégré dans le bras robotisé 600, ou dans une électronique du bras robotisé.

Alternativement, le conditionneur 204 peut être intégré dans une électronique de détection capacitive équipant le bras robotisé 600.

Bien sûr, l'invention n'est pas limitée aux exemples qui viennent d'être décrits et de nombreux aménagements peuvent être apportés à ces exemples sans sortir du cadre de l'inventior défini par les revendications ci-jointes.

## Revendications

1. Appareil (200;600) comprenant :
- au moins une électrode (108), dite de mesure, polarisée à un potentiel électrique alternatif (V_{G}), dit de détection, différent d'un potentiel de masse, à une fréquence, dite de détection, pour détecter au moins un objet (122) dans une zone de détection (124),
- au moins une électronique de détection capacitive (100), reliée à ladite ou lesdites électrodes de mesure (108), pour détecter un signal relatif à une capacité de couplage entre ledit objet (122) et ladite ou au moins une desdites électrodes de mesure (108), et
- une ligne électrique (202) comprenant au moins un fil électrique (302), dans ladite zone de détection (124) ;
ledit appareil (200;600) comprenant en outre un conditionneur (204), appliquant, à au moins une partie de ladite ligne électrique (202), un potentiel électrique alternatif (V_{G}), dit de garde, identique audit potentiel de détection à ladite fréquence de détection.

2. Appareil (200;600) selon la revendication 1, **caractérisé en ce que** la ligne électrique (202) comprend au moins une couche de blindage (304;402) autour d'au moins un fil électrique (302) sur au moins une partie de ladite ligne électrique (202), le conditionneur (204) appliquant le potentiel de garde (V_{G}) à ladite couche de blindage (304;402).

3. Appareil (200;600) selon la revendication précédente, **caractérisé en ce que** la couche de blindage (304) est prévue dans un câble (310) comprenant l'au moins un fil électrique (302).

4. Appareil (200;600) selon la revendication 2, **caractérisé en ce que** la couche de blindage (402) est prévue dans, ou est formée par, un passe câble (406), indépendant de l'au moins un fil électrique (302), et dans lequel est passé l'au moins un fil électrique (302).

5. Appareil (200;600) selon l'une quelconque des revendications 3 ou 4, **caractérisé en ce que** la couche de blindage (304;402) se présente sous la forme de fils tressés formant une tresse de blindage.

6. Appareil (200;600) selon l'une quelconque des revendications 3 ou 4, **caractérisé en ce que** la couche de blindage (304;402) se présente sous la forme d'une couche conductrice continue.

7. Appareil (200;600) selon l'une quelconque des revendications 2 à 6, **caractérisé en ce que** le conditionneur (204) comprend un transformateur induisant le potentiel de garde (V_{G}) sur ladite couche de blindage (304;402), par mutuelle inductance.

8. Appareil (200;600) selon l'une quelconque des revendications 2 à 6, **caractérisé en ce que** le conditionneur (204) comprend au moins un contact électrique (308) avec la couche de blindage (304;402) pour polariser ladite couche de blindage (304;402) au potentiel de garde (V_{G}).

9. Appareil (200;600) selon l'une quelconque des revendications précédentes, **caractérisé en ce que** le conditionneur (204) applique le potentiel de garde (V_{G}) à au moins un, en particulier chaque, fil électrique (302) de la ligne électrique (202).

10. Appareil (200;600) selon la revendication précédente, **caractérisé en ce que** la ligne électrique comprend des fils électriques concentriques, et le conditionneur (204) applique le potentiel de garde (V_{G}) uniquement au fil externe.

11. Appareil (200;600) selon l'une quelconque des revendications 9 ou 10, **caractérisé en ce que** le conditionneur (204) comprend, pour au moins un, en particulier chaque, fil électrique (302), un transformateur induisant le potentiel de garde sur ledit fil électrique (302), par mutuelle inductance.

12. Appareil (200;600) selon l'une quelconque des revendications précédentes, **caractérisé en ce qu'**il comprend au moins une électrode (106), dite de garde, polarisée au potentiel de garde (V_{G}), et agencée du côté opposée à la zone de détection (124) par rapport à l'au moins une électrode de mesure (108).

13. Appareil (200;600) selon l'une quelconque des revendications précédentes, **caractérisé en ce que** la ligne électrique (202) comporte au moins une électrode de mesure capacitive polarisée au potentiel de détection, disposée à l'extérieure par rapport à la partie de ladite ligne électrique (202) polarisée au potentiel de garde (V_{G}), et isolée de ladite partie polarisée au potentiel de garde.

14. Appareil (200;600) selon l'une quelconque des revendications précédentes, **caractérisé en ce que** la ligne électrique (202) est une ligne d'alimentation de, et/ou de communication avec, un organe électrique (610) dudit appareil.

15. Appareil (200;600) selon l'une quelconque des revendications précédentes, **caractérisé en ce qu'**il s'agit d'un robot (600) se présentant sous l'une des formes suivantes : bras robotisé, robot mobile, véhicule sur roues ou chenilles, robot de type humanoïde, ou gynoïde, ou androïde.

## Patentansprüche

1. Gerät (200; 600), umfassend:
- mindestens eine sogenannte Mess-Elektrode (108), welche mit einem sich vom Erdungsmassenpotential unterscheidenden, sogenannten erfassenden elektrischen Wechselpotential (V_{G}) zu einer sogenannten Erfassungsfrequenz zur Erfassung mindestens eines Objekts (122) in einer Erfassungszone (124) polarisiert ist,
- mindestens eine kapazitive Sensorelektrode (100), welche mit der oder den Messelektroden (108) verbunden ist, um ein Signal in Bezug auf eine Kopplungskapazität zwischen dem Objekt (122) und der oder mindestens einer der Messelektroden (108) zu erfassen, und
- eine elektrische Leitung (202) in der Erfassungszone (124), welche mindestens einen Elektrodraht (302) umfasst;
wobei das Gerät (200; 600) außerdem einen Konditionierer (204) umfasst, welcher ein elektrisches, sogenanntes Schirmwechselpotential (V_{G}) gleich dem Erfassungspotential zu der Erfassungsfrequenz auf wenigstens einen Teil der elektrischen Leitung (202) anlegt.

2. Gerät (200; 600) nach Anspruch 1, **dadurch gekennzeichnet, dass** die elektrische Leitung (202) wenigstens eine um mindestens einem Elektrodraht (302) auf wenigstens einem Teil der elektrischen Leitung (202) gelagerte Abschirmschicht (304; 402) umfasst, wobei der Konditionierer (204) das Schirmpotential (V_{G}) auf die Abschirmschicht (304; 402) anlegt.

3. Gerät (200; 600), nach dem vorhergehenden Anspruch, **dadurch gekennzeichnet, dass** die Abschirmschicht (304) in einem Kabel (310) vorgesehen ist, das den mindestens einen Elektrodraht (302) umfasst.

4. Gerät (200; 600) nach Anspruch 2, **dadurch gekennzeichnet, dass** die Abschirmschicht (402) in einem von dem wenigstens einen Elektrodraht (302) unabhängigen Leerrohr (406) gelagert oder durch einen Leerrohr (406) ausgebildet ist, in welchem der wenigstens eine Elektrodraht (302) durchgezogen ist.

5. Gerät (200; 600) nach einem der Ansprüche 3 oder 4, **dadurch gekennzeichnet, dass** die Abschirmschicht (304; 402) in der Form von geflochtenen, ein Schirmgeflecht bildenden Drähten ausgebildet ist.

6. Gerät (200; 600) nach einem der Ansprüche 3 oder 4, **dadurch gekennzeichnet, dass** die Abschirmschicht (304; 402) in der Form einer durchgehenden, leitenden Schicht ausgebildet ist.

7. Gerät (200; 600) nach einem der Ansprüche 2 bis 6, **dadurch gekennzeichnet, dass** der Konditionierer (204) einen Transformator umfasst, welcher das Schirmpotential (VG) auf die Abschirmschicht (304; 402) durch wechselseitige Induktanz induziert.

8. Gerät (200; 600) nach einem der Ansprüche 2 bis 6, **dadurch gekennzeichnet, dass** der Konditionierer (204) wenigstens einen elektrischen Kontakt (308) mit der Abschirmschicht (304, 402) zur Polarisierung der Abschirmschicht (304; 402) mit dem Schirmpotential (V_{G}) umfasst.

9. Gerät (200; 600) nach einem der vorhergehenden Ansprüche, **dadurch gekennzeichnet, dass** der Konditionierer (204) das Schirmpotential (V_{G}) auf wenigstens einen, insbesondere jeden Elektrodraht (302) der elektrischen Leitung (202) anlegt.

10. Gerät (200; 600) nach dem vorhergehenden Anspruch, **dadurch gekennzeichnet, dass** die elektrische Leitung konzentrische Elektrodrähte umfasst, und der Konditionierer (204) das Schichtpotential (V_{G}) ausschließlich auf den äußeren Draht anlegt.

11. Gerät (200; 600) nach einem der Ansprüche 9 oder 10, **dadurch gekennzeichnet, dass** der Konditionierer (204) für wenigstens einen, insbesondere für jeden Elektrodraht (302) einen Transformator umfasst, der das Schirmpotential auf den Elektrodraht (302) durch wechselseitige Induktanz induziert.

12. Gerät (200; 600) nach einem der vorhergehenden Ansprüche, **dadurch gekennzeichnet, dass** es wenigstens eine sogenannte Abschirmelektrode (106) umfasst, welche mit dem Schirmpotential (V_{G}) polarisiert und auf der gegenüberliegenden Seite der Erfassungszone (124) im Verhältnis zu der mindestens einen Messelektrode (108) gelagert ist.

13. Gerät (200; 600) nach einem der vorhergehenden Ansprüche, **dadurch gekennzeichnet, dass** die elektrische Leitung (202) mindestens eine kapazitive Messelektrode umfasst, welche mit dem Erfassungspotential polarisiert, im Verhältnis zum mit dem Schirmpotential (V_{G}) polarisierten Teil der elektrischen Leitung (202) außen gelagert und von dem mit dem Schirmpotential polarisierten Teil isoliert ist.

14. Gerät (200; 600) nach einem der vorhergehenden Ansprüche, **dadurch gekennzeichnet, dass** die elektrische Leitung (202) eine Versorgungs- und/oder Kommunikationsleitung mit einem elektrischen Element (610) des Geräts ist.

15. Gerät (200; 600) nach einem der vorhergehenden Ansprüche, **dadurch gekennzeichnet, dass** es sich um einen Roboter (600) handelt, der in einer der folgenden Formen ausgebildet ist: robotischer Arm, mobiler Robot, Fahrzeug mit Rädern oder Raupenkette, humanoider, gynoider oder androider Roboter.

## Claims

1. Appliance (200;600) comprising:
- at least one electrode (108), called measurement electrode, polarized at an alternating electrical potential (V_{G}), called detection potential, different from a ground potential, at a frequency, called detection frequency, in order to detect at least one object (122) in a detection zone (124),
- at least one capacitive detection electronics (100), connected to said measurement electrode(s) (108), in order to detect a signal with respect to a coupling capacitance between said object (122) and said measurement electrode (108) or at least one of said measurement electrodes (108), and
- an electric line (202) comprising at least one electric wire (302), in said detection zone (124);
said appliance (200;600) also comprising a signal conditioner (204), applying, to at least a portion of said electric line (202), an alternating electrical potential (V_{G}), called guard potential, identical to said detection potential at said detection frequency.

2. Appliance (200;600) according to claim 1, **characterized in that** the electric line (202) comprises at least one shielding layer (304;402) around at least one electric wire (302) on at least a portion of said electric line (202), the signal conditioner (204) applying the guard potential (V_{G}) to said shielding layer (304; 402).

3. Appliance (200;600) according to the preceding claim, **characterized in that** the shielding layer (304) is provided in a cable (310) comprising the at least one electric wire (302).

4. Appliance (200;600) according to claim 2, **characterized in that** the shielding layer (402) is provided in, or is formed by, a cable sleeve (406) independent of the at least one electric wire (302), and through which is passed the at least one electric wire (302).

5. Appliance (200;600) according to any one of claims 3 or 4, **characterized in that** the shielding layer (304;402) is in the form of braided wires forming a shielding braid.

6. Appliance (200;600) according to any one of claims 3 or 4, **characterized in that** the shielding layer (304;402) is in the form of a continuous conductive layer.

7. Appliance (200,600) according to any one of claims 2 to 6, **characterized in that** the signal conditioner (204) comprises a transformer inducing the guard potential (V_{G}) on said shielding layer (304;402), by mutual inductance.

8. Appliance (200;600) according to any one of claims 2 to 6, **characterized in that** the signal conditioner (204) comprises at least one electrical contact (308) with the shielding layer (304; 402) in order to polarize said shielding layer (304; 402) at the guard potential (V_{G}).

9. Appliance (200;600) according to any one of the preceding claims, **characterized in that** the signal conditioner (204) applies the guard potential (V_{G}) to at least one, in particular each, electric wire (302) of the electric line (202).

10. Appliance (200;600) according to the preceding claim, **characterized in that** the electric line comprises concentric electric wires, and the signal conditioner (204) applies the guard potential (V_{G}) to the outer wire only.

11. Appliance (200;600) according to any one of claims 9 or 10, **characterized in that** the signal conditioner (204) comprises, for at least one, in particular each, electric wire (302), a transformer inducing the guard potential on said electric wire (302) by mutual inductance.

12. Appliance (200;600) according to any one of the preceding claims, **characterized in that** it comprises at least one electrode (106), called guard electrode, polarized at the guard potential (V_{G}), and arranged on the side opposite the detection zone (124) with respect to the at least one measurement electrode (108).

13. Appliance (200;600) according to any one of the preceding claims, **characterized in that** the electric line (202) comprises at least one capacitive measurement electrode polarized at the detection potential, arranged on the outside with respect to the portion of said electric line (202) polarized at the guard potential (V_{G}), and isolated from said portion polarized at the guard potential.

14. Appliance (200;600) according to any one of the preceding claims, **characterized in that** the electric line (202) is an electric power supply line for, and/or for communication with, an electric component part (610) of said appliance.

15. Appliance (200;600) according to any one of the preceding claims, **characterized in that** it is a robot (600) in one of the following forms: robotized arm, mobile robot, vehicle on wheels or tracks, robot of the humanoid, or gynoid, or android type.
